# EUROPEAN PATENT SPECIFICATION

(11) **EP 2 137 959 B1**
(45) Date of publication and mention of the grant of the patent: **26.10.2011**
(21) Application number: 07846443.5
(22) Date of filing: 05.12.2007
(51) Int. Cl.: H04N 5/217, H04N 3/14, H04N 5/18, H04N 5/243, H04N 5/335

(54) **LONG EXPOSURE DIGITAL IMAGE SENSOR SYSTEM**
DIGITALES BILDSENSORSYSTEM FÜR LANGZEITBELICHTUNG
SYSTÈME DE CAPTEUR D'IMAGE NUMÉRIQUE À EXPOSITION LONGUE

(30) Priority: 19.03.2007 DK 200700417
(43) Date of publication of application: 30.12.2009
(73) Proprietor: Phase One A/S, 2000 Frederiksberg (DK)
(72) Inventor: ANDERSEN, Thomas, 4600 Køge (DK)
(74) Representative: Plougmann & Vingtoft A/S
(86) International application number: PCT/DK2007/050181
(87) International publication number: WO 2008/052569

(56) References cited:
- EP-A- 1 615 426
- US-A- 5 757 440
- US-A1- 2001 008 268
- US-A1- 2003 011 698
- US-A1- 2006 109 360
- US-A1- 2006 237 629
- US-B1- 6 750 910

## Description

### FIELD OF THE INVENTION

The invention relates to a method for improving image quality of a digital image sensor, and in particular to improving the image quality of a digital image sensor for long exposure periods.

### BACKGROUND OF THE INVENTION

The quality of images from digital image processors is affected by electric noise from various electrical and optical noise sources. In particular when using long exposure times for imaging under dark light conditions, the noise source may significantly degrade the image quality. The digital image may be processed using measured or estimated noise values in order to remove such noise effects from the image.

One noise source is optical black noise which is dependent on temperature of the image sensor. Images can be corrected for optical black noise by use of electrical values obtained from shielded pixels of the image sensor. For example, by clamping the image signal with respect to such electrical values obtained from shielded pixels.

In connection with long exposure imaging, localised heating of the image sensor is a problem, since localised heating causes localised noise. Such localised heating may be caused by e.g. amplifier circuits located close to the image sensor.

Another problem is clipping (i.e. the max signal value is limited to a threshold values) of the image signal by an analogue-to-digital converter. The noise values which are added to images values which implies that the image signal may be so large that the signal is clipped, for example by analogue-to-digital converter.

JP2005303592 discloses a solid state imaging device including a first optical black level pixel which is formed under a light shielding film and which does not have a photoelectric conversion function, and a second optical black level pixel with a photoelectric conversion function. The signal processing method for determining the optical black level includes a step of selectively clamping any of an output signal from the first optical black level pixel, and an output signal from the second optical black level pixel according to the exposure time and the two black levels.

Whereas JP2005303592 discloses a method for correcting for optical black noise by using values from shielded or non-shielded pixels, JP2005303592 does not effectively disclose how to improve image quality due to other noise sources and due to clipping of the image signal.

US 5757440 discloses an apparatus for removing low frequency noise and any offsets common to a plurality of samples of a signal, for calibrating an offset level to be added to the signal to reference the signal to a desired reference level at an output of the apparatus, and for clamping an input voltage level to the apparatus to a desired voltage within an operating range of the apparatus. The apparatus includes a black level correction circuit which adds an offset level to the difference signal to calibrate the offset level to be added to the difference signal so that the difference signal is at a desired reference level at an output of the apparatus. Further, the apparatus includes a clamping circuit which servos a voltage at the output of the correlated double-sampling circuit to a desired voltage level at the input to the correlated double-sampling circuit and within the supply range and operating range of the apparatus.

US 2006237629 discloses a digital camera which includes an image sensor having an array of CCD (Charge-Coupled Device) cells on which an optical image is focused. The image signal is clamped by an analog front end circuit, which feeds a processed analog signal to an analog-to-digital converter. The resultant digital signal is input to a signal processor. The analog front end circuit switches horizontal scanning lines to be clamped in accordance with image pickup information. The horizontal scanning lines to be clamped lie in an optical black area where a photodiode is included in each CCD cell or an optical black area where the former is not included in the latter.

US 6750910 discloses an apparatus for providing optical black and offset calibration for an array signal comprising a sequence of voltage levels corresponding to a sequence of voltage samples of charge coupled devices arranged in an array. The apparatus includes a correlated double sampler adapted to receive the array signal and provide as an output a modified array signal comprising a sequence of first corrected output voltage levels. A programmable gain amplifier receives the modified array signal and provides as an output an amplified modified array signal comprising a sequence of second corrected output voltage levels. An analog to digital converter receives the amplified modified array signal and provides as an output a sequence of digital values. A digital signal storage device stores a digital value corresponding to a desired optical black level. A digital to analog converter stores a correction value corresponding to a determined correction and compensates the amplified modified array signal, based on the correction value, for variations from a desired black level. A correction digital circuit determines an average value corresponding to an average of a plurality of the digital values, subtracts that average value from, and adds a previously stored correction value to, the digital value to determine a current correction value. The current correction value is provided as the current correction value to the digital to analog converter for use thereby.

EP 1615426 discloses a signal processing device including a solid-state image pickup element having a pixel part including an effective pixel area to be irradiated with light, and a vertical light-shielded pixel area where irradiation of light is shielded, a vertical scanning circuit, a horizontal scanning circuit, and an output circuit, a clamp section which clamps, to a predetermined reference value; black level values of pixel signals from the vertical light-shielded pixel area and effective pixel area, a threshold determination section which determines a threshold value, based on the predetermined reference value, a determination section which determines whether or not pixel signals from the vertical light-shielded pixel area that have the black level value clamped to the reference value by the clamp section exceed the threshold value determined by the threshold determination section, a defective pixel detector which detects a defective pixel among pixels arranged in the vertical light-shielded pixel area, and a signal processor which performs a predetermined signal processing on pixel signals from the vertical light-shielded pixel area that have a black level value clamped to the reference value by the clamp section.

US 2006109360 discloses a solid-state image device including pixels arranged two-dimensionally, the pixels each including a photoelectric converter for converting incident light into an electric signal, is provided. The solid-state image device includes an output amplifier configured to amplify a photoelectric conversion output from each of the pixels, and a reference voltage amplifier configured to output a reference voltage. The solid-state image device selectively outputs the photoelectric conversion output and the reference voltage.

US 2003011698 discloses a solid-state imaging device comprising, on a semiconductor substrate, a plurality of sensor sections for storing a signal charge commensurate with a quantity of reception light, a charge transfer section for transferring and outputting the signal charge of the sensor sections, and an output section for converting the signal charge transferred by the charge transfer section into an imaging signal for output. A current controller is provided to cut off or reduce a current flowing to the output section in a signal storage period of the sensor section. This cuts off or reduces the current flowing to the output section in a signal storage period of the sensor section, and hence suppresses the amount of the current flowing to the output section in the signal storage period. Thus, wasteful consumption power is greatly reduced.

US 2001008268 discloses a drive circuit having a differential amplifier, a current controller formed from an n-channel MOSFET, and a drive ability control circuit sets its output drive ability in a high state only in a signal read, and otherwise sets the output drive ability in a low state to reduce power consumption. Thus, a solid-state image sensing device which can perform a high-speed read while ensuring low power consumption and wide dynamic range can be implemented. As the drive ability control circuit, for example, a current source formed from an n-channel MOSFET and voltage switching by a drive change-over switch can be used

### SUMMARY OF THE INVENTION

Accordingly, the invention preferably seeks to mitigate, alleviate or eliminate one or more of the above mentioned problems singly or in any combination. In particular, it may be seen as an object of the present invention to provide a method and an apparatus capable of capable of improving the image quality in connection with long exposure imaging by clamping the image signal using an electric black reference signal.

This object and several other objects are obtained in a first aspect of the invention by providing an image sensor system according to the independent claims.

The invention is particularly, but not exclusively, advantageous for improving the image quality in connection with long exposure imaging.

Accordingly, an embodiment of the first aspect of the invention relates to an image sensor system as defined in claim 1.

The electric black reference signal may represent electric black noise and may, therefore, correspond to the electric black noise contained in the image signal. Thus, by adjusting the image signal using the electric black signal, for example by subtracting the electric black signal from the image signal, a clamped image signal substantially free from electric black noise may be achieved.

Another advantage related to adjusting the image signal using the electric black signal may be achieved, since the clamped image signal may not be exposed to clipping in a possible subsequent analogue-to-digital converter where the clamped signal is digitized.

In an embodiment, electric black reference signal may represent electric noise embedded in the image signal. It is understood, that representing electric noise may be understood as being substantially equal to or representing a fraction of the embedded electric noise, i.e. the noise contained in the image signal. Thus, the electric black reference signal may represent e.g. 50 percent of the embedded electric noise.

In an embodiment, the electric black reference signal may be substantially free from optical noise being embedded in the image signal. Thus, depending on how the electric black reference signal is obtained, the electric reference signal may contain an amount of optical noise.

In an embodiment, the electric black reference signal may be generated from one or more additional values transmitted by a horizontal register, where the additional values are transmitted by the horizontal register subsequent to pixel values.

In another corresponding embodiment, the electric black reference signal is generated from one or more additional values transmitted from one or more vertical registers of the image sensor, where the additional values are transmitted from the vertical registers subsequent to pixel values.

Thus, such additional values may not be generated due to optical radiation since the values may be generated by an electric register circuit. It may be an advantage that the electric black reference signal is generated from one or more additional values transmitted by a horizontal register, since the electric reference value is then substantially free from optical noise.

In a similar embodiment, the electric black reference signal is generated by a feedback circuit comprising a processing device configured to extract electric noise values from a digitised image signal and converting the extracted electric noise values into the electric black reference signal.

In a further embodiment, in the image sensor system according to the first aspect,
- the electric reference generator is configured to provide an electric black reference signal comprising values of one or more lines of the image sensor, and
- the clamping circuit is configured to adjust one or more reference levels of the image signal related to corresponding one or more of lines of the image sensor using the electric black reference signal, where the adjusted reference levels of the image signal have values relative to the lower clipping reference for avoiding clipping of the clamped image signal.

Thus, it may be an advantage to use values from one or more image sensor lines for generating the electric black reference value since this allows the claiming circuit to adjust corresponding one or more signal values from one or more lines of the image signal. Since the image signal may be adjusted for a plurality of lines, an improved image quality may advantageously be obtained and/or a reduced risk for clipping in the ADC may advantageously be achieved.

In an embodiment, in the image sensor system according to the first aspect,
- the analogue to digital converter is configured to convert the clamped image signal into a digitized pixel signal, and the system further comprises,
- a black level compensator configured to adjust the digitized image signal related to each line of the image sensor, where each line is adjusted using values originating from one or more shielded pixels from one or more lines to obtain a black-level conditioned digitized image signal.

Thus, in addition to correcting for electric black noise by clamping, the image signal may be corrected for unwanted optical black noise.

In an embodiment, the image sensor system further comprises a selector for selecting an exposure mode selected from the list comprising: a short exposure mode and a long exposure mode, wherein
- the selector is configured to provide the clamping circuit with the electric black reference signal when the long exposure mode is selected, and
- the selector is configured to provide the clamping circuit with an optical black reference signal when the short exposure mode is selected.

Thus, when capturing an image using a long exposure time (e.g. under dark light conditions), the clamping circuit may advantageously be provided with the electric black reference signal, since this may give the best image quality under long exposures. Oppositely, when capturing an image using a short exposure time, the clamping circuit may advantageously be provided with the optical black reference signal (e.g. obtained from shielded pixels), since this may give the best image quality under short exposure times.

It may be an advantage to use a current controller, since the current controller may be capable of reducing heating and, thereby, improve the image quality, in particular for long exposure imaging.

In another aspect, the invention relates to a method for adjusting a reference level of an image signal readout from an electronic image sensor as defined by the independent claims

The above aspects of the present invention may each be combined with any of the other aspects. These and other aspects of the invention will be apparent from and elucidated with reference to the embodiments described hereinafter.

In summary, the invention relates to an image sensor system which includes an image sensor. The image from the image sensor may be read out as a video signal. In addition to image values, the video signal may also contain electrical and optical black noise. Such noises should be removed from the video signal. A value corresponding to the electrical black noise may be obtained from the image sensor by reading out same additional pixel values which does not originate from image pixels. By subtracting this value from the video signal, a clamped video signal may be obtained in which the electrical black noise has been reduced or removed. Additionally, by subtracting the electric block noise value, it may be achieved that the clamped video signal is not clipped in the analogue-to-digital converter. The optical black noise may be removed from the signal outputted by the ADC.

### BRIEF DESCRIPTION OF THE FIGURES

The present invention will now be explained, by way of example only, with reference to the accompanying Figures, where
Figure 1 illustrates an image sensor and an image sensor signal,
Figure 2 illustrates optical noise and electrical noise as a function of exposure time,
Figure 3 shows an example of an electric reference generator,
Figure 4 shows an optical black noise compensator,
Figure 5 shows an interline image sensor with vertical registers,
Figure 6 shows how an electric black reference signal can be generated by a feedback circuit,
Figure 7 shows a selector for selecting either short exposure or long exposure, and
Figure 8 shows an image sensor system and an electric chip system.

### DETAILED DESCRIPTION OF AN EMBODIMENT

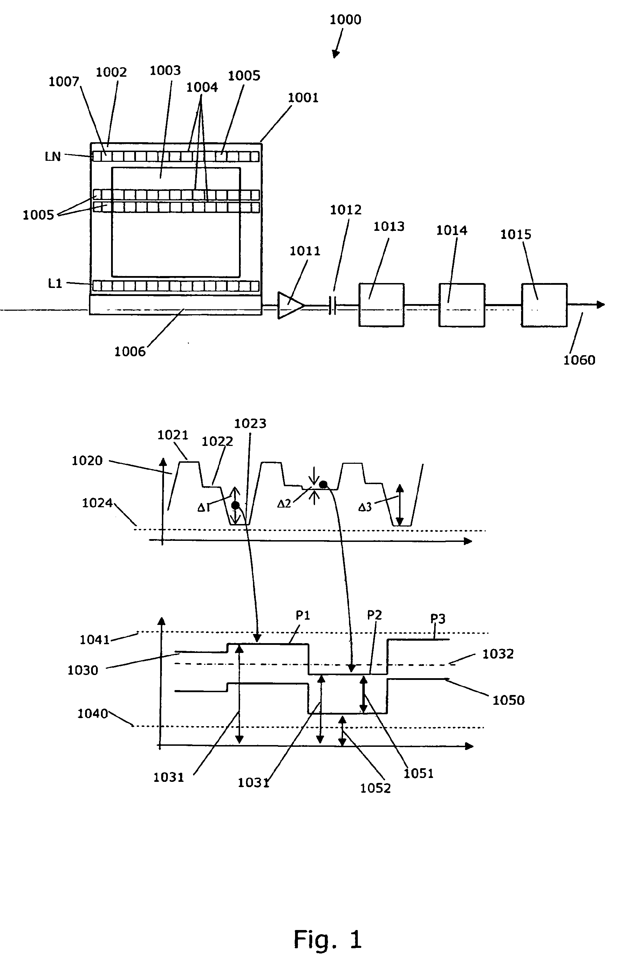

Figure 1 illustrates an image sensor system 1000 comprising an image sensor 1001, a horizontal register 1006, an amplifier 1011, a capacitor 1012, Correlated Double Sampler (CDS) 1013, a clamping circuit 1014 and an analogue to digital converter (ADC) 1015.

The image sensor 1001 contains lines of pixels 1004 where each line 1004 contains a number of photosensitive pixels 1005. Each pixel 1005 is capable of storing an amount of electric charge corresponding partly to the amount of light radiated onto the pixel. However, the amount of charge stored in the pixel 1005 is also influenced by optical noise sources, for example black current, and other electrical noise sources. Accordingly the charge stored in the pixels 1005 originates primarily from light radiated onto the pixel 1005, optical noise sources and electrical noise sources.

The image sensor 1001 has en active area 1003 where light radiation propagates freely into the pixels 1005. The image sensor also has a shielded area 1002 where the pixels 1005 are shielded so that light cannot propagate into the pixels. Accordingly, charge stored in the light shielded pixels 1005 originates primarily from optical noise sources and electrical noise sources. Those pixels 1005 that are located in the shielded area 1002 are referred to as shielded pixels 1007.

The image sensor 1001 is typically used in a camera for imaging for example a landscape onto the active area 1003 by means of an imaging lens. The charges stored in the image sensor 1001 are readout and processed to form a digital image.

The optical black noise generally refers to any kind of undesired current or voltage generated by the photosensitive pixels 1005. The optical black noise may be dependent or independent of the light radiated onto the pixels 1005 and may be dependent of for example the temperature of the photosensitive pixels 1005. Thus, the term "black" refers to the fact that the optical black noise is generated even if no light is radiated into the pixels.

The image sensor 1001 may be a charge coupled image sensor (CCD), a CMOS image sensor or other image sensors known to the skilled person. Similarly, the image sensor 1001 may full frame type, a interline type or other types.

The pixels 1005 are read out from image sensor via the horizontal register 1006. Initially, the charges of the pixels 1005 of the first line L1 are transferred to the horizontal register. The charges are read out from the horizontal register 1006 as a video signal 1020. The video signal 1020 may be amplified by amplifier 1011 and it may be filtered by capacitor 1012 before the image signal is supplied to the Correlated Double Sampler (CDS) 1013.

The video signal 1020 includes a reset pulse 1021, a reference level 1022 and a pixel level 1023. The value of reference level 1022 may be affected by residue charges of the capacitor 1012 and, therefore, the reference level 1022 may not constant during reading out the pixels 1005. The difference of the reference level 1022 and the pixel level 1023 corresponds to the charge stored in a single pixel 1005. The maximum level of the video signal 1020 is indicated by the maximum level 1024.

The Correlated Double Sampler (CDS) 1013 generates the image signal 1030 having pixel levels 1031 corresponding to the difference between the reference level 1022 and the pixel level 1023. Thus, the pixel level 1031 of pixel P1 corresponds to the difference Δ1 between the reference level 1022 and the pixel level 1023, the pixel level 1031 of pixel P2 corresponds to Δ2, the pixel level 1031 of pixel P3 corresponds to Δ3, and so on.

Now, the image signal 1030 could be transmitted to the analogue to digital converter (ADC) 1015. The ADC 1015 digitizes the image signal into a digital image signal, for example a 16 bit digital signal. The ADC is characterised by a lower clipping limit 1040 and a full scale limit 1041. In order not do destroy the digital image from the image sensor, the pixel level 1031 of the image signal 1030 should not go below the lower clipping limit 1040. On the other hand, if the pixel level 1031 of the image signal 1030 exceeds the full scale limit 1041 the pixel level 1031 will be clipped to the value of the full scale limit 1041. Thus, to fully exploit the dynamic range of the ADC 1015, the reference level 1032 of the image signal 1030 should be adjusted so that a minimum pixel level 1031, eg. the pixel level 1031 of pixel P2, does not go below the lower clipping limit 1040.

Therefore, the image signal 1030 is supplied to the clamping circuit 1014 which adjusts the reference level 1032 of the image signal relative to the lower clipping reference 1040 resulting in a clamped image signal 1050 transmitted by the clamping circuit. Thus, the clamping circuit 1015 ensures that any pixel level 1031 does not go below the clipping limit 1040 and, thereby, avoids clipping of the clamped image signal 1050.

Thus, the value of the level shift 1051 between the image signal 1030 and the clamped image signal 1050 must be chosen carefully in order to avoid clipping of the clamped image signal 1050.

The pixel levels 1031, which are equivalent to the charges stored in the pixels 1005, are generated by contributions primarily from light radiated onto the pixels 1005, optical noise sources and electrical noise sources.

The configuration of the image sensor system 1000 is not limited to the configurations depicted in the figures but may be configured differently. For example, one or more of the
the amplifier 1011, the CDS 1013, the clamping circuit 1014 and the ADC 1015 may be combined into one or more circuits, such as the CDS 1013 being combined with the clamping circuit 1014 into a combined CDS and clamping circuit 1014. Also, one or more of the circuits may be integrated with the image sensor 1001 or the horizontal register 1006.

The signals, i.e. the image signal 1030, 1050, the digital image signal 1060 and the video signal 1020, are not limited to those particular signal types illustrated in the Figures. Clearly, other image sensors and those electronic circuits related to the image sensor, for example the register 1006, the amplifier 1011, the CDS 1013, the clamping circuit 1014 and the ADC 1015, may be configured to provide other types of image signals. Therefore, reference to the video signals 1020 and the image signals 1030, 1050 is not limited to particular signals illustrated in the figures or described. Accordingly, reference to an image signal 1020, 1030, 1050 should be understood as a reference to any image signal 1030, 1050, video signal 1020 or digital image signal 1060. Oppositely, reference to a video signal 1020 or an image signal 1030, 1050 should not be limited to that particular signal, since in general image signals and video signals may have different forms.

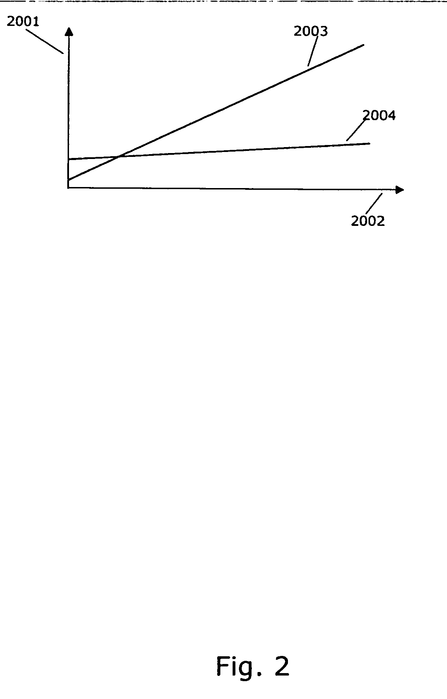

The curves 2003 and 2004 in Figure 2 illustrates the fraction (along the ordinate 2001) of the pixel level 1031 which is caused by optical noise 2003 and the electrical noise 2004 as a function of exposure time 2002. The exposure time is the period of time in which the pixels 1005 are exposed to light being imaged onto the image sensor 1001, for example by an imaging lens.

Accordingly, by adjusting the reference level 1032 of the image signal 1030, for example by providing a level shift 1051 to the image signal 1030 corresponding to a value of the optical noise 2003 or the electrical noise 2004, would bring a minimum pixel level 1031 closer to clipping limit 1040 and, thereby, increase the dynamic range of the analogue to digital converter 1015. An increased dynamic range implies a higher resolution of the digital signal generated by the ADC 1015.

Furthermore, by adjusting the reference level 1032 of the image signal 1030 using a value or a signal corresponding to the optical noise 2003 or the electrical noise 2004⁻would also compensate the image signal 1030 for the optical noise 2003 or the electrical noise 2004, respectively. That is, a truer image signal 1030 is obtained since unwanted noise is removed from the image signal 1030.

However, when adding or subtracting a level shift 1051 to the image signal 1030 it must be assured that the pixel level 1052 of the clamped image signal 1050 does not exceed the lower clipping limit 1040.

An optical black reference signal representing the optical noise 2003 can be obtained by reading out shielded pixels, for example by averaging a number of shielded pixels 1007 for each line 1004 or a number of lines 1004 to obtain an optical black reference signal or an optical black reference value. Experiences have shown that use of an optical black reference signal to provide a level shift 1051 to the image signal 1030 may cause clipping of the clamped image signal 1050 since one or more pixel levels 1052 exceed the lower clipping limit 1040. This is particularly the case for long exposure times. A Long exposure time may be considered as an exposure time longer than 0.01 second eg. under normal daylight photographing, longer than 0.1 second eg. for photographing under weak light conditions, longer than one second or even longer than one minute eg. for photographing under very low light conditions such as night photographing. In the extreme the exposure time may be measured in hours.

However, it has been observed that use of a signal value equivalent to the electrical noise 2004 is useful to provide a level shift 1051 to the image signal 1030. In particular it has shown that the use of a signal value equivalent to the electrical noise 2004 does not cause any lower pixel levels 1052 to exceed the lower clipping limit 1040 and, therefore, the quality of the digital image is not decreased due to clipping of the clamped image signal 1050.

Thus, by using a signal or a value corresponding to the electrical noise 2004, the dynamic range of the ADC 1015 is better exploited without causing clipping of the clamped image signal 1050. In addition, since the level shift 1051 applied to the image signal 1030 corresponds to the electric noise 2004, the electric noise 2004 is removed, or at least partially removed, from the image signal 1030 so that a more correct digital image is obtained.

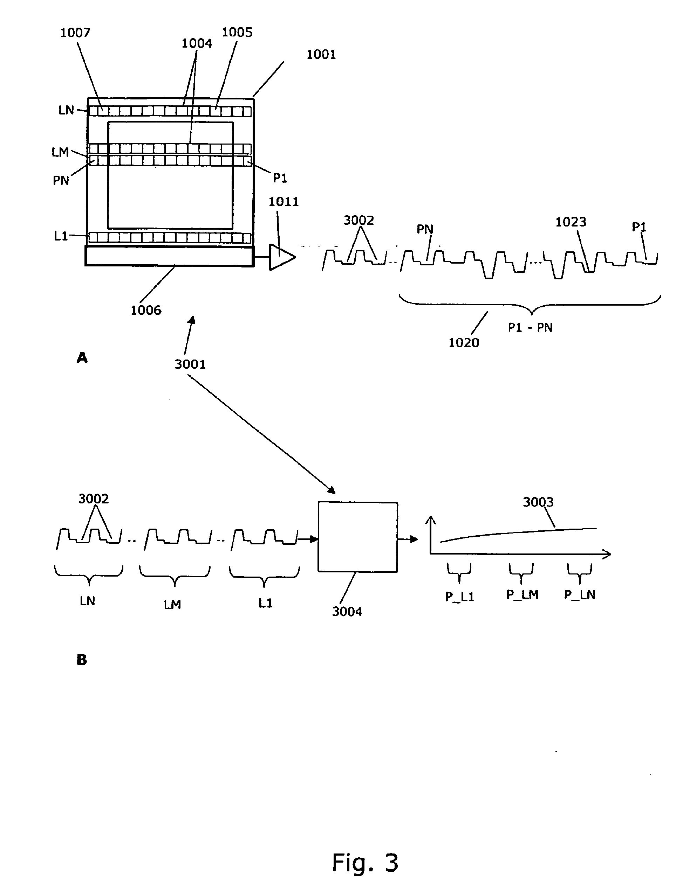

Figure 3 shows in one example of an electric reference generator 3001 how the horizontal register 1006 can be used as the electric reference generator 3001 to provide an electric black reference signal 3003 corresponding to the electrical noise 2004.

The term "black" in the electric black reference signal 3003 refers to the fact that the electric black reference signal 3003 corresponds to electrical noise 2004 being generated even when the pixels 1005 are not exposed to light.

In part A of Figure 3 the pixels P1-PN, comprising pixels 1005 from the active area 1003 and the shielded area 1002, of line LM are readout as the video signal 1020 comprising pixel values 1023. By reading out or transmitting one or more additional values 3002 from the horizontal register subsequent to reading out the pixel values 1023, the additional values 3002 can be used to obtain the electric black reference signal 3003 as will be described in relation to part B of Figure 3.

Part B of Figure 3 shows how a sequence of additional values 3002 are readout for a sequence of lines L1-LN. The electric black reference signal 3003 may be generated from the additional values 3002 for example by sampling the additional values 3002 and subsequently averaging or filtering the sampled additional values 3002 using a filter 3004 so as to obtain a smooth and continuous electric black reference signal 3003, for example as depicted. For example the additional values 3002 from line L1 may be combined, eg. by averaging, to form a single electric noise value for line L1, or only one additional value 3002 may be extracted for each line 1004 to form a single electric noise value for each line 1004. To form the continuous electric black reference signal 3003, the electric noise values for each line 1004 may be combined, eg. by filtering. In an alternative the electric black reference signal 3003 may be obtained directly from the additional values 3002 without performing filtering or averaging, for example by sampling the additional values 3002. If a filter 3004 is used it may be integrated with the electric reference generator 3001 or otherwise provided with the image sensor system 1000.

Since the electric noise 2004 varies during readout of the lines 1004 of pixels 1005, the electric reference generator 3001 may be configured to provide values of the electric black reference signal 3003 for a one or more of lines 1004 (eg. lines L1,..,LM,..,LN) of the image sensor 1001. As shown in part B of Figure 3, additional values 3002 associated with one or more of lines L1,..,LM,..,LN are converted to form the electric black reference signal 3003. Values of the electric black reference signal 3003 corresponding to one or more lines L1,..,LM,..,LN may be obtained from the electric black reference signal 3003 for example by sampling the electric black reference signal 3003 within periods P_L1,..,P_LM,..,P_LN corresponding to lines L1,..,LM,..,LN.

It should be understood that additional values 3002 may be selected from only one line 1004 to form the electric black reference signal 3003, or values 3002 may be selected from every second, every third, etc. line 1004 to form the electric black reference signal 3003.

Accordingly, for operating the clamping circuit 1014 on a line-by-line basis, the clamping circuit 1014 is configured to adjust a plurality of reference levels 1032 of the image signal 1030 related to a plurality of lines L1,..,LM,..,LN using values of the electric black reference signal 3003 corresponding to respective lines L1,..,LM,..,LN. Accordingly, level shifts 1051 are applied to the image signal 1030 for a plurality of lines L1,..,LM,..,LN of the image signal 1030, where each level shift 1051 is obtained from the electric black reference signal 3003 for corresponding lines L1,..,LM,..,LN.

It should be understood that level shifts 1051 may be applied to the image signal 1030 of any number of lines 1004. For example, only one level shift 1051 may be applied to one line 1004 of the lines L1-LN, or level shifts 1051 may be applied to every second, every third, etc. lines 1004.

It may be an advantage that the electric black reference signal 3003 is smooth and continuous so that the level shifts 1051 applied to the image signal 1030 does not change too much between lines 1004. If the level shifts 1051 changes too much between lines 1004 this may result in visible fringes in the digital image.

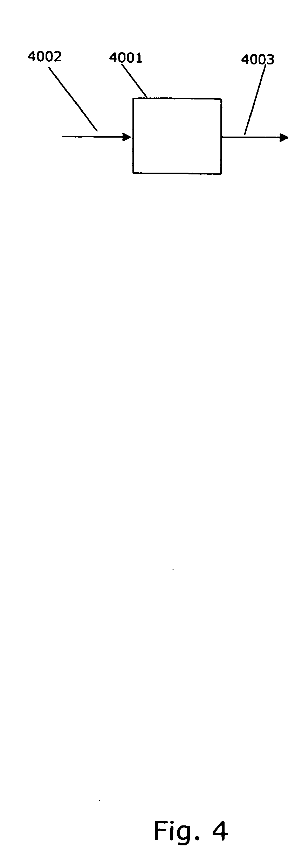

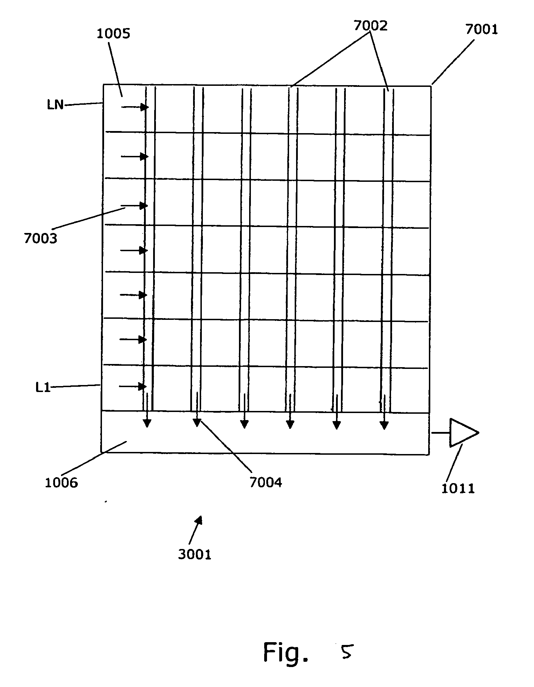

Figure 5 shows an interline image sensor 7001 comprising pixels 1005, vertical registers 7002, a horizontal register 1006 and an amplifier 1011. The charges stored in the pixels 1005 are readout from the image sensor 7001 by first shifting the charges from the pixels 1005 to the vertical registers 7002 as indicated by arrows 7003. From the vertical registers 7002 the charges are shifted into the horizontal register 1006 starting from line L1 as indicated with arrows 7004. When the charges from the last line LN has been readout into the horizontal register 1004, the vertical registers have been emptied for charges generated by the pixels 1005. However, by carrying out another shift of the vertical registers 7002 into the horizontal register 1006, the horizontal register 1006 will be filled with charges having values corresponding to the electrical noise 2004. By transmitting these additional values of electrical noise 2004 from the vertical registers 7002 and using a filter 3004 for performing filtering or averaging to obtain an electric black reference signal 3003, the image signal 1030 can be converted into the clamped image signal 1050, for example by subtracting values of the electric black reference signal 3003 from the image signal 1030 as described in relation to Figure 4. Clearly, one or more additional values of electrical noise 2003 can be transmitted from only one vertical register or from a plurality of vertical registers 7003. Accordingly, the vertical registers 7002 in combination with the horizontal register 1006 can be seen as an electric reference generator 3001.

The generation of an electric black reference signal 3003 is not limited to using values from additional values transmitted by the horizontal register 1006 or additional values transmitted from one or more vertical registers 7002. Indeed, the electric black reference signal 3003 can be generated by data processing or data analysis of other image signals, such as the video signal 1020, the image signal 1030 or the digitized image signal 1060.

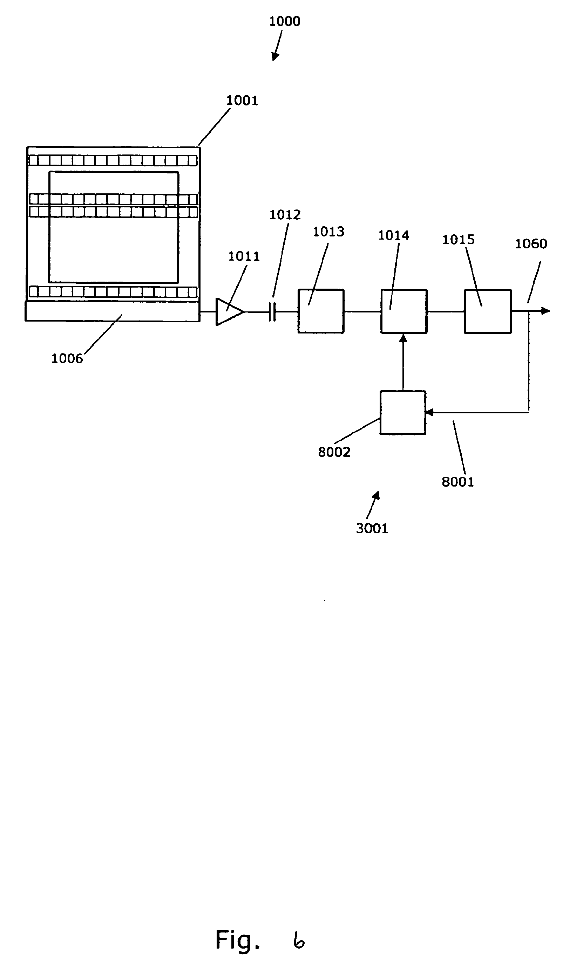

Figure 6 shows how the electric black reference signal 3003 can be generated by a feedback circuit 8001 using the digitized image signal 1060 as a feedback signal. The feedback signal is processed by the processing device 8002. Thus, the processing device extracts electric noise values 2003 from a digitised image signal 1060 and converts the extracted electric noise values into the electric black reference signal 3003. The electric black reference signal 3003 is supplied to the clamping circuit 1014 so that the reference level 1032 of the image signal 1030 is adjusted relative to the lower clipping reference 1040 of the ADC 1015 so that clipping of the clamped image 1050 signal is avoided. The feedback circuit 8001 and the processing device may be configured to adaptively generate the electric black reference signal 3003 so the reference level 1032 of the image signal 1030 is adaptively adjusted relative to the reference level 1032. Thus, in this feedback example the feedback circuit 8001 and the processing device 8002 can be seen as an electric reference generator 3001.

After the electrical black noise 2004 has been removed from the image signal 1030, the resulting clamped image signal 1050 can be supplied to the analogue to digital converter 1015 which converts the clamped image signal into a digitized image signal 1060 read out from the analogue to digital converter 1015.

The digital image signal 1060 which has been corrected for electrical noise 2004 still contains optical noise 2003. However, the digitized image signal 1060 can be corrected for optical black noise 2003 by use of the shielded pixels 1007. The shielded pixels 1007 are not exposed to light during exposure of the digital image and, therefore, the charges stored in the shielded pixels 1007 corresponds to the optical black noise 2003.

The pixel levels 1032 of the shielded pixels 1007 can be extracted either from the analogue image signal 1030 or from the digitized image signal 1060. Since each line 1004 contains one or more shielded pixels 1007, one pixel level 1032 or more pixel levels 1032 from corresponding shielded pixels 1007, eg from line LM, can be filtered or averaged to form a single optical black value representing the optical black noise for line LM.

Figure 4 shows an optical black noise compensator 4001 configured to correct the digitized image signal for optical black noise by adjusting the level of the digitized image signal 1060 relative to the optical black values. For example this may be carried out by subtracting the optical black values of each line 1004 from the digitized image signal 1060. Alternatively, an optical black reference signal may be generated by filtering or averaging all the optical black values obtained for each line 1004 so as to generate a smooth and continuous optical black reference signal. By using values from the optical black reference signal and subtracting those values from the digitized image signal 1060 a black-level conditioned digitized image signal which is substantially corrected for optical black noise 2003 is obtained.

The optical black noise compensator 4001 may be supplied with the digitized image signal 1060 via input 4002. From the digitized image signal 1060 which contains pixels levels 1023 both from shielded pixels 1007 and pixels 1005, the optical black noise compensator 4001 may generate the optical black reference signal and/or optical black values, and by using the optical black reference signal or the optical black values the optical black noise compensator 4001 may generate and transmit a black-level conditioned signal via output 4003.

In general the black level compensator 4001 is configured to adjust the digitized image signal 1060 by adjusting each line 1004 of the image sensor, where each line is adjusted using values originating from one or more shielded pixels 1007 from one or more lines 1004 to obtain a black-level conditioned digitized image signal. That is, for example the value from only one shielded pixel 1007 selected from any line 1004 may be used to adjust each line 1004, or the values from shielded pixel 1007 selected by selecting one shielded pixel from each of a plurality of lines 1004, eg. every second line, may be used to adjust each line 1004, or the values from shielded pixel 1007 selected by selecting a plurality of shielded pixel from each of a plurality of lines 1004, eg. every second line, may be used to adjust each line 1004. In a preferred embodiment a plurality of pixel values 1032 from shielded pixel 1007 are averaged for each line 1004, and the averaged values from all lines 1004 are filtered to obtain an optical black reference signal, and the optical black reference signal is used to generate the black-level conditioned signal.

It may be beneficial to be able to select different image exposure modes in dependence of the length of the exposure period. Clearly, for long exposure periods the clamping circuit 1014 should adjust the reference level 1032 of the image signal 1030 using the electric black reference signal 3003 obtained from an electric reference generator 3001. However, for short exposure periods, eg shorter than 0.1 seconds, preferable shorter than 0.01 seconds, it may in some situations be beneficial to configure the clamping circuit 1014 to adjust the reference level 1032 of the image signal 1030 using an optical black reference signal or optical black values as described in connection with Figure 4. Therefore, it may be beneficial to be able provide the clamping circuit 1014 with the electrical black reference signal 3003 or the optical black reference signal in dependence of the length of the image exposure period.

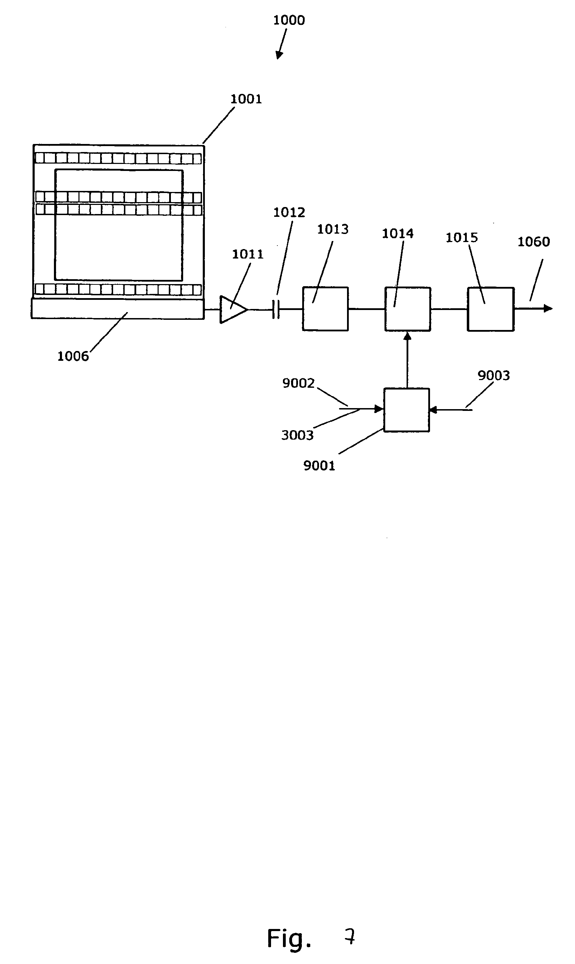

Figure 7 shows a configuration of the image sensor system 1000 comprising a selector 9001 for selecting either a short exposure mode or a long exposure mode so that the selector provides the clamping circuit 1014 with the electric black reference signal 3003 when the long exposure mode is selected and the selector provides the clamping circuit 1014 with the optical black reference signal or optical black values when the short exposure mode is selected. The selection of the short or long exposure modes may be carried out automatically, for example by a processing device of a camera, or the selection may be carried out manually, for example by the user of a camera.

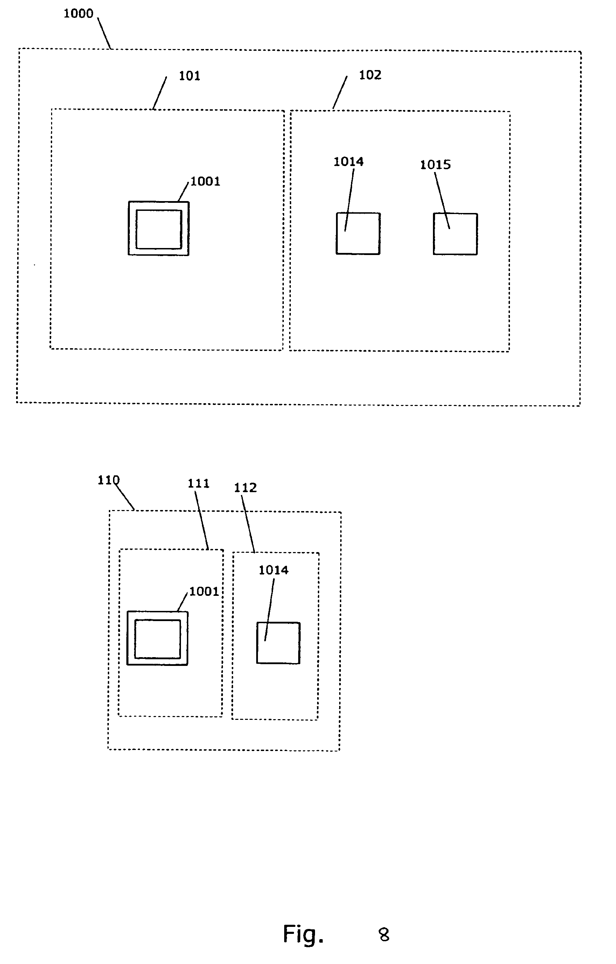

Figure 8 shows an image sensor system 1000. As indicated by subsystems 101 and 102, the image sensor system 1000 may be comprised by one or more subsystems corresponding to subsystems 101 and 102. For example, one subsystem 101 may comprise the image sensor 1001. The other subsystem 102 may for example comprise the clamping circuit 1014 and the analogue to digital converter (ADC) 1015. Clearly, the devices and components of the image sensor system may be grouped differently in various subsystems. Also, in this or other embodiments the subsystems 101 and 102 may comprise further devices, for example subsystem 101 may comprise anyone or more of the horizontal register 1006, the amplifier 1011. Also, in this or other embodiments the subsystem 102 may comprise anyone or more of the capacitor 1012 and the Correlated Double Sampler 1013.

The image sensor system 1000 comprises an electric reference generator 3001 which may be comprised by the subsystem 101 or 102 or other subsystems comprised by the image sensor system 1000. As described previously, the electric reference generator 3001 may be embodied by the horizontal register 1006, the vertical registers 7002 in combination with the horizontal register 1006, or the feedback circuit 8001 in combination with the processing device 8002.

In an embodiment, the image sensor system 1000 comprises a black level compensator 4001. In another embodiment the image sensor system 1000 comprises a selector 9001. In an embodiment the image sensor system comprises a filter 3004 for use with the electric reference generator 3001.

One of the subsystems comprised by the image sensor system may be an electronic chip system 110, for example an integrated electronic circuit. The electronic chip system 110 may comprise the image sensor 1001 and the clamping circuit 1014. Again, the electronic chip system 110 may be divided into two subsystems 111 and 112, where subsystem 111 comprises the image sensor 1001 and subsystem 112 comprises the clamping circuit 1014.

The subsystems 101 of 102 of the image sensor system 1001 and/or the subsystems 111 and 112 of the electronic chip system 110 may be comprised by a single apparatus, for example a camera. Alternatively, anyone or more of the subsystems 101 of 102 of the image sensor system 1001 and/or the subsystems 111 and 112 of the electronic chip system 110 may be distributed over different apparatuses. For example, subsystem 101 may be contained in a camera whereas the subsystem 102 may be contained in an auxiliary apparatus (not depicted) connectable with the camera. Similarly, the electronic chip system 110 may comprised by a single integrated electronic circuit. Alternatively, the electronic chip system 110 may comprised by for example two electronics chip systems corresponding to the subsystem 111 and the subsystem 112, respectively.

Anyone or more of the subsystems 101 of 102 of the image sensor system 1001 and/or the subsystems 111 and 112 of the electronic chip system 110 may be implemented in hardware or in software. The hardware may be an electronic circuit, such as components on a printed circuit board, or the hardware may be an integrated electronic circuit, such as an electronic chip device.

The software may be embedded software, such as software embedded in an electronic chip circuit, or the software may be a computer program adapted for running on a computer.

Accordingly, the image sensor system 1000 may comprise a subsystem 101 implemented in hardware and a subsystem 102 implemented in software. Similarly, the electronic chip system 110 may comprise a subsystem 111 implemented in hardware and a subsystem 112 implemented in software.

In the above description various figures have been reused for different embodiments. When elements of a figure have already been explained in relation to a previous embodiment, those elements are not necessarily explained in relation to the new embodiment since the function of that element, eg the amplifier 1011, in the new embodiment is identical to or equivalent to the function in the previous embodiment.

## Claims

1. An image sensor system (1000) configured to adjust a reference level (1032) of an image signal (1030) readout from an electronic image sensor (1001) comprising an active area (1003) and a light shielded area (1002) of photosensitive pixels (1005) via a horizontal register (1006) or vertical registers (7002), the image signal (1030) representing analogue pixel values (Δ1- Δ3) of a digital image recorded by the image sensor (1001), the image sensor system comprising,
- an electric reference generator (3001) configured to provide an electric black reference signal (3003) representing electric noise (2004) embedded in the image signal (1030),
- a clamping circuit (1014) configured to obtain a clamped image signal (1050) by adjusting the reference level (1032) of the image signal readout from the electronic image sensor (1001) using the electric black reference signal (3003),
- an analogue to digital converter (1015) having a lower clipping reference (1040) for digitizing the clamped image signal (1050),
wherein the reference level (1032) of the image signal (1030) is adjusted relative to the lower clipping reference (1040) for avoiding that a minimum pixel level (1031) of the image signal (1030) goes below the lower clipping limit (1040), and
the clamped image signal (1050) is obtained prior to digitizing the clamped image signal, and wherein the electric black reference signal (3003) is generated from one or more additional values (3002), not originating from pixels (1005) from the active area (1003) or the light shielded area (1002), but read out of the horizontal register (1006) or the one or more vertical registers (7002) in additional reads performed subsequently to shifting out charges captured for pixel values (1023) of the photosensitive pixels (1005).

2. The image sensor system according to any of the preceding claims, wherein the electric black reference signal (3003) is substantially free from optical noise (2003) being embedded in the image signal (1030).

3. The image sensor system according to any of the preceding claims, wherein the electric black reference signal (3003) is generated by a feedback circuit (8001) comprising a processing device (8002) configured to extract electric noise values (2004) from a digitised image signal (1060) and converting the extracted electric noise values into the electric black reference signal (3003).

4. The image sensor system according to any of the preceding claims, wherein
- the electric reference generator (3001) is configured to provide an electric black reference signal (3003) comprising values of one or more lines (1004) of the image sensor (1001), and
- the clamping circuit (1014) is configured to adjust one or more reference levels (1032) of the image signal (1030) related to corresponding one or more of lines (1004) of the image sensor (1001) using the electric black reference signal (3003), where the adjusted reference levels (1032) of the image signal (1030) have values relative to the lower clipping reference (1040) for avoiding clipping of the clamped image signal.

5. The image sensor system according to any of the preceding claims, wherein
- the analogue to digital converter is configured to convert the clamped image signal (1050) into a digitized pixel signal (1060), the system further comprising,
- a black level compensator (4001) configured to adjust the digitized image signal (1060) related to each line (1004) of the image sensor, where each line (1004) is adjusted using values originating from one or more shielded pixels (1007) from one or more lines (1004) to obtain a black-level conditioned digitized image signal.

6. The image sensor system according to any of the preceding claims, further comprising a selector (9001) for selecting an exposure mode selected from the list comprising: a short exposure mode and a long exposure mode, wherein
- the selector (9001) is configured to provide the clamping circuit (1014) with the electric black reference signal (3003) when the long exposure mode is selected, and
- the selector (9001) is configured to provide the clamping circuit (1014) with an optical black reference signal when the short exposure mode is selected.

7. A method for adjusting a reference level (1032) of an image signal (1030) readout from an electronic image sensor (1001) comprising an active area (1003) and a light shielded area (1002) of photosensitive pixels (1005) via a horizontal register (1006) or vertical registers (7002), the image signal (1030) representing analogue pixel values (Δ1- Δ3) of a digital image recorded by the image sensor (1001), the method comprising,
- providing an electric black reference signal (3003) from an electric reference generator (3001), the black reference signal representing electric noise (2004) embedded in the image signal (1030),
- adjusting the reference level of the image signal read out from the electronic image sensor using the electric black reference signal for obtaining a clamped image signal,
- digitizing the clamped image signal using an analogue to digital converter (ADC) having a lower clipping reference,
wherein the reference level of the image signal is adjusted relative to the lower clipping reference for avoiding that a minimum pixel level (1031) of the image signal (1030) goes below the lower clipping limit (1040), and the clamped image signal is obtained prior to digitizing the clamped image signal, and wherein the electric black reference signal (3003) is generated from one or more additional values (3002), not originating from pixels (1005) from the active area (1003) or the light shielded area (1002), but read out of the horizontal register (1006) or the one or more vertical registers (7002) in additional reads performed subsequently to shifting out charges captured for pixel values (1023) of the photosensitive pixels (1005).

## Patentansprüche

1. Bildsensorsystem (1000), konfiguriert zum Justieren eines Bezugswerts (1032) eines Auslesens eines Bildsignals (1030) von einem elektronischen Bildsensor (1001), umfassend einen aktiven Bereich (1003) und einen lichtgeschützten Bereich (1002) lichtempfindlicher Pixel (1005), über ein horizontales Register (1006) oder vertikale Register (7002), wobei das Bildsignal (1030) analoge Pixelwerte (Δ1- Δ3) eines vom Bildsensor (1001) aufgenommenen digitalen Bilds repräsentiert, wobei das Bildsensorsystem umfasst
- einen elektrischen Bezugsgenerator (3001), der zum Bereitstellen eines elektrisch schwarzen Bezugssignals (3003) konfiguriert ist, das im Bildsignal (1030) eingebettetes elektrisches Rauschen (2004) repräsentiert,
- Klemmschaltung (1014), die durch Justieren des Bezugswerts (1032) des Auslesens des Bildsignals von dem elektronischen Bildsensor (1001) unter Verwendung des elektrisch schwarzen Bezugssignals (3003) zum Erhalt eines geklemmten Bildsignals (1050) konfiguriert ist,
- einen Analog-Digital-Wandler (1015) mit einem unteren Begrenzungsbezugswert (1040) zum Digitalisieren geklemmten Bildsignals (1050),
wobei der Bezugswert (1032) des Bildsignals (1030) im Verhältnis zu dem unteren Begrenzungsbezugswert (1040) justiert wird, um zu vermeiden, dass ein Mindestpixelwert (1031) des Bildsignals (1030) niedriger wird als der untere Begrenzungsbezugswert (1040), und wobei das geklemmte Bildsignal (1050) vor der Digitalisierung des geklemmten Bildsignals erhalten wird und wobei das elektrisch schwarze Bezugssignal (3003) aus einem oder mehreren zusätzlichen Werten (3002) generiert wird, die nicht von Pixeln (1005) des aktiven Bereichs (1003) oder des lichtgeschützten Bereichs (1002) stammen, sondern von dem horizontalen Register (1006) oder dem einen oder den mehreren vertikalen Registern (7002) in zusätzlichen Auslesevorgängen ausgelesen werden, die nach dem Verschieben von Ladungen für die Pixelwerte (1023) der lichtempfindlichen Pixel (1005) durchgeführt werden.

2. Bildsensorsystem nach einem der vorhergehenden Ansprüche, wobei das elektrisch schwarze Bezugssignal (3003) im Wesentlichen frei von optischem Rauschen (2003) ist, das im Bildsignal (1030) eingebettet.

3. Bildsensorsystem nach einem der vorhergehenden Ansprüche, wobei das elektrisch schwarze Bezugssignal (3003) von einer Rückkopplungsschaltung (8001) erzeugt wird, die eine Verarbeitungsvorrichtung (8002) umfasst, die zum Extrahieren elektrischer Rauschwerte (2004) aus einem digitalisierten Bildsignal (1060) und dem Umwandeln der extrahierten elektrischen Rauschwerte in das elektrisch schwarze Bezugssignal (3003) konfiguriert ist.

4. Bildsensorsystem nach einem der vorhergehenden Ansprüche, wobei
- der elektrische Bezugsgenerator (3001) derart konfiguriert ist, dass ein elektrisch schwarzes Bezugssignal (3003) bereitgestellt wird, das einen oder mehrere Zeilen (1004) des Bildsensors (1001) umfasst, und
- die Klemmschaltung (1014)zum Justieren von einem oder mehreren Bezugswerten (1032) des Bildsignals (1030) betreffend eine oder mehrere entsprechende Zeilen (1004) des Bildsensors (1001) unter Verwendung des elektrisch schwarzen Bezugssignals (3003) konfiguriert ist, wobei die justierten Bezugswerte (1032) des Bildsignals (1030) Werte in Bezug zu dem unteren Begrenzungsbezugswert (1040) haben, um eine Begrenzung des geklemmten Bildsignals zu vermeiden.

5. Bildsensorsystem nach einem der vorhergehenden Ansprüche, wobei
- der Analog-Digital-Wandler zum Umwandeln des geklemmten Bildsignals (1050) in ein digitalisiertes Pixelsignal (1060) konfiguriert ist, wobei das System weiterhin umfasst
- einen Schwarzwertkompensator (4001), der zum Justieren des digitalisierten Bildsignals (1060) betreffend jede Zeile (1004) des Bildsensors konfiguriert ist, wobei jede Zeile (1004) unter Verwendung von Werten justiert ist, die von einem oder mehreren geschützten Pixels (1007) von einer oder mehr Zeilen (1004) stammen, um ein schwarzwertkonditioniertes digitales Bildsignal zu erhalten.

6. Bildsensorsystem nach einer der vorhergehenden Ansprüche, weiterhin umfassend einen Selektor (9001) zum Auswählen eines Belichtungsmodus, ausgewählt aus der Liste, umfassend: einen Kurzbelichtungsmodus und ein Langbelichtungsmodus, wobei
- der Selektor (9001) zum Bereitstellen der Klemmschaltung (1014) mit dem elektrisch schwarzen Bezugssignal (3003) konfiguriert ist, wenn der Langbelichtungsmodus gewählt ist, und
- der Selektor (9001) zum Bereitstellen der Klemmschaltung (1014) mit einem optisch schwarzen Bezugssignal konfiguriert ist, wenn der Kurzbelichtungsmodus gewählt ist, und

7. Verfahren zum Justieren eines Bezugswerts (1032) eines Auslesens eines Bildsignals (1030) von einem elektronischen Bildsensor (1001), umfassend einen aktiven Bereich (1003) und einen lichtgeschützten Bereich (1002) lichtempfindlicher Pixel (1005), über ein horizontales Register (1006) oder vertikale Register (7002), wobei das Bildsignal (1030) analoge Pixelwerte (Δ1-Δ3) eines vom Bildsensor (1001) aufgenommenen digitalen Bilds repräsentiert, wobei das Verfahren umfasst
- Bereitstellen eines elektrisch schwarzen Bezugssignals (3003) von einem elektrischen Bezugsgenerator (3001), wobei das schwarze Bezugssignal im Bildsignal (1030) eingebettetes elektrisches Rauschen (2004) repräsentiert,
- Justieren des Bezugswerts des Auslesens des Bildsignals von dem elektronischen Bildsensor unter Verwendung des elektrisch schwarzen Bezugssignals zum Erhalt eines geklemmten Bildsignals,
- Digitalisieren des geklemmten Bildsignals unter Verwendung eines Analog-Digital-Wandlers (ADC) mit einem unteren Begrenzungsbezugswert, wobei der Bezugswert des Bildsignals im Verhältnis zu dem unteren Begrenzungsbezugswert justiert wird, um zu vermeiden, dass ein Mindestpixelwert (1031) des Bildsignals (1030) niedriger wird als der untere Begrenzungsbezugswert (1040), und wobei das geklemmte Bildsignal vor der Digitalisierung des geklemmten Bildsignals erhalten wird und wobei das elektrisch schwarze Bezugssignal (3003) aus einem oder mehreren zusätzlichen Werten (3002) generiert wird, die nicht von Pixeln (1005) des aktiven Bereichs (1003) oder des lichtgeschützten Bereichs (1002) stammen, sondern von dem horizontalen Register (1006) oder dem einen oder den mehreren vertikalen Registern (7002) in zusätzlichen Auslesevorgängen ausgelesen werden, die nach dem Verschieben von Ladungen für die Pixelwerte (1023) der lichtempfindlichen Pixel (1005) durchgeführt werden.

## Revendications

1. Système de capteur d'image (1000) configuré pour régler un niveau de référence (1032) d'un signal d'image (1030) lu sur un capteur d'image (1001) électronique comprenant une zone active (1003) et une zone protégée contre la lumière (1002) de pixels (1005) photosensibles via un registre horizontal (1006) ou des registres verticaux (7002), le signal d'image (1030) représentant des valeurs de pixel analogiques (Δl - Δ3) d'une image numérique enregistrée par le capteur d'image (1001), le système de capteur d'image comprenant
- un générateur de référence électrique (3001) configuré pour produire un signal de référence de noir électrique (3003) représentant le bruit électrique (2004) intégré au signal d'image (1030),
- un circuit de verrouillage (1014) configuré pour obtenir un signal d'image verrouillé (1050) en réglant le niveau de référence (1032) du signal d'image lu sur le capteur d'image (1001) électronique en utilisant le signal de référence de noir électrique (3003),
- un convertisseur analogique-numérique (1015) possédant une référence d'écrêtage inférieure (1040) pour numériser le signal d'image verrouillé (1050), dans lequel le niveau de référence (1032) du signal d'image (1030) est réglé par rapport à la référence d'écrêtage inférieure (1040) pour éviter qu'un niveau de pixel minimum (1031) du signal d'image (1030) devienne inférieur à la limite d'écrêtage inférieure (1040), et le signal d'image verrouillé (1050) est obtenu avant la numérisation du signal d'image verrouillé, et dans lequel le signal de référence de noir électrique (3003) est généré à partir d'une ou de plusieurs valeurs supplémentaires (3002), ne provenant pas de pixels (1005) de la zone active (1003) ou de la zone protégée contre la lumière (1002), mais lues dans le registre horizontal (1006) ou les un ou plusieurs registres verticaux (7002) lors de lectures supplémentaires réalisées après la sortie par décalage des charges capturées pour les valeurs de pixel (1023) des pixels (1005) photosensibles.

2. Le système de capteur d'image selon l'une quelconque des revendications précédentes, dans lequel le signal de référence de noir électrique (3003) est essentiellement exempt de bruit optique (2003) intégré au signal d'image (1030).

3. Le système de capteur d'image selon l'une quelconque des revendications précédentes, dans lequel le signal de référence de noir électrique (3003) est généré par un circuit de bouclage (8001) comprenant un dispositif de traitement (8002) configuré pour extraire des valeurs de bruit électrique (2004) d'un signal d'image numérisé (1060) et convertir les valeurs de bruit électrique extraites en ce signal de référence de noir électrique (3003).

4. Le système de capteur d'image selon l'une quelconque des revendications précédentes, dans lequel
- le générateur de référence électrique (3001) est configuré pour produire un signal de référence de noir électrique (3003) comprenant des valeurs d'une ou de plusieurs lignes (1004) du capteur d'image (1001), et
- le circuit de verrouillage (1014) est configuré pour régler un ou plusieurs niveaux de référence (1032) du signal d'image (1030) associés à une ou plusieurs lignes (1004) correspondantes du capteur d'image (1001) en utilisant le signal de référence de noir électrique (3003), où les niveaux de référence (1032) réglés du signal d'image (1030) possèdent des valeurs relatives à la référence d'écrêtage inférieure (1040) pour éviter d'écrêter le signal d'image verrouillé.

5. Le système de capteur d'image selon l'une quelconque des revendications précédentes, dans lequel
- le convertisseur analogique-numérique est configuré pour convertir le signal d'image verrouillé (1050) en signal de pixel numérisé (1060), le système comprenant également
- un compensateur de niveau de noir (4001) configuré pour régler le signal d'image numérisé (1060) associé à chaque ligne (1004) du capteur d'image, où chaque ligne (1004) est réglée en utilisant des valeurs provenant d'un ou de plusieurs pixels protégés (1007) provenant d'une ou de plusieurs lignes (1004) pour obtenir un signal d'image numérisé conditionné par le niveau de noir.

6. Le système de capteur d'image selon l'une quelconque des revendications précédentes, comprenant également un sélecteur (9001) pour sélectionner un mode d'exposition choisi dans la liste comprenant : un mode d'exposition courte et un mode d'exposition longue, dans lequel
- le sélecteur (9001) est configuré pour fournir au circuit de verrouillage (1014) le signal de référence de noir électrique (3003) quand le mode d'exposition longue est sélectionné, et
- le sélecteur (9001) est configuré pour fournir au circuit de verrouillage (1014) un signal de référence de noir optique quand le mode d'exposition courte est sélectionné.

7. Méthode de réglage d'un niveau de référence (1032) d'un signal d'image (1030) lu sur un capteur d'image (1001) électronique comprenant une zone active (1003) et une zone protégée contre la lumière (1002) de pixels (1005) photosensibles via un registre horizontal (1006) ou des registres verticaux (7002), le signal d'image (1030) représentant des valeurs de pixel analogiques (Δ1 - Δ3) d'une image numérique enregistrée par le capteur d'image (1001), la méthode comprenant
- apport d'un signal de référence de noir électrique (3003) provenant d'un générateur de référence électrique (3001), le signal de référence de noir représentant le bruit électrique (2004) intégré au signal d'image (1030),
- réglage du niveau de référence du signal d'image lu sur le capteur d'image électronique en utilisant le signal de référence de noir électrique pour obtenir un signal d'image verrouillé,
- numérisation du signal d'image verrouillé en utilisant un convertisseur analogique-numérique (ADC) possédant une référence d'écrêtage inférieure, dans laquelle le niveau de référence du signal d'image est réglé par rapport à la référence d'écrêtage inférieure pour éviter qu'un niveau de pixel minimum (1031) du signal d'image (1030) devienne inférieur à la limite d'écrêtage inférieure (1040), et le signal d'image verrouillé est obtenu avant la numérisation du signal d'image verrouillé, et dans laquelle le signal de référence de noir électrique (3003) est généré à partir d'une ou de plusieurs valeurs supplémentaires (3002), ne provenant pas de pixels (1005) de la zone active (1003) ou de la zone protégée contre la lumière (1002), mais lues dans le registre horizontal (1006) ou les un ou plusieurs registres verticaux (7002) lors de lectures supplémentaires réalisées après la sortie par décalage des charges capturées pour les valeurs de pixel (1023) des pixels (1005) photosensibles.
